# EUROPEAN PATENT SPECIFICATION

(11) **EP 4 391 049 B1**
(45) Date of publication and mention of the grant of the patent: **28.05.2025**
(21) Application number: 22216219.0
(22) Date of filing: 22.12.2022
(51) Int. Cl.: H01L 23/528, H01L 23/48, H01L 23/535, H01L 23/473

(54) **A MICRO-ELECTRONIC COMPONENT COMBINING POWER DELIVERY AND COOLING FROM THE BACK SIDE**
MIKROELEKTRONISCHES BAUELEMENT MIT KOMBINIERTER STROMVERSORGUNG UND KÜHLUNG VON DER RÜCKSEITE
COMPOSANT MICRO-ÉLECTRONIQUE COMBINANT LA DISTRIBUTION D'ÉNERGIE ET LE REFROIDISSEMENT À PARTIR DE LA FACE ARRIÈRE

(43) Date of publication of application: 26.06.2024
(73) Proprietor: Imec VZW, 3001 Leuven (BE)
(72) Inventor: Oprins, Herman, 3020 Herent (BE); Van der Plas, Geert, 3000 Leuven (BE); Beyne, Eric, 3001 Heverlee (BE); Woeltgens, Pieter, 5508PB Veldhoven (NL)
(74) Representative: Patent Department IMEC

(56) References cited:
- US-A1- 2010 155 932
- US-A1- 2020 365 509

## Description

### Field of the Invention

The present invention is related to micro-electronic components such as integrated circuit chips, and in particular to the cooling of such components.

### State of the art.

Integrated circuit chips and other semiconductor-based micro-electronic components comprise a number of well-known constituent parts, including a front end of line (FEOL) portion that comprises a large number of semiconductor devices such as transistors and diodes processed on the front side of a semiconductor substrate according to a given layout. On top of the FEOL portion, the back end of line (BEOL) portion is processed, consisting of a network of interconnected electrical conductors embedded in a dielectric material, and coupled to the devices in the FEOL, for providing signal routing into and out of the devices. In many existing IC designs, the BEOL portion also includes the power delivery network (PDN), i.e. the conductors configured to be coupled to a power supply voltage and a reference (usually ground) voltage for supplying power to the active devices in the FEOL.

As the number of devices on the chip increases, this conventional frontside PDN approach has created a competition in the BEOL between signal routing and power delivery, forcing trade-offs in terms of routing resources, as well as technology optimizations that have led to compromises which are non-optimal for signals as well as for power.

For this reason, designs were developed wherein the power delivery network was taken out of the BEOL and moved to the back side of the chip. This back side PDN comprises, like the front side BEOL, multiple interconnect levels which are now solely dedicated to the supply of power to the FEOL. The back side PDN frees up space on the front side for signal routing. The back side PDN approach is described for example in patent publication document EP3324436

A defining issue for any of these configurations however is related to the cooling of the component. Heat is generated in the FEOL and needs to be removed to ensure device reliability. The main thermal concern with the back side PDN integration is the higher self-heating due to the significantly thinned or even completely removed bulk substrate portion of the chip, and the increased presence of materials with low thermal conductivity (for example oxides) in the thermal path compared to conventional front side power delivery integration.

The patent publication US2010/155932 A1 discloses a chip stack wherein a cooling manifold is provided on the back side of each chip.

### Summary of the invention

The invention aims to provide a solution to the problems highlighted above. This aim is achieved by micro-electronic components and methods in accordance with the appended claims.

A micro-electronic component according to the invention, for example an integrated circuit chip, comprises a FEOL and a BEOL portion at its front side, in accordance with any known design. A back side PDN is furthermore present at the back side of the component, with via connections connecting the PDN to the FEOL and BEOL portions at the front side. The back side PDN of a component of the invention is different from prior art designs, in that it comprises a 'dry part' and a 'wet part' : the dry part includes multiple interconnect levels of the PDN which are closest to the FEOL portion. These levels are embedded in a dielectric material, as known in the art. The 'wet part' comprises the remaining PDN levels which are however not embedded in a dielectric but which are part of a manifold structure configured to receive therein a flow of cooling fluid in order to remove heat generated by the devices in the FEOL portion.

This configuration enables more efficient cooling compared to conventional back side PDN designs by reducing the use of dielectric materials in the PDN, and by bringing the cooling fluid closer to the heat source, namely the active devices in the FEOL portion.

The invention is in particular related to a micro-electronic component having a front side and a back side, the component comprising :
- at the front side of the component : a front end of line (FEOL) portion comprising a plurality of semiconductor devices and on said FEOL portion : a back end of line (BEOL) portion (42) comprising multiple interconnect levels,
- at the back side of the component : a power delivery network (PDN) comprising multiple interconnect levels, and power supply terminals electrically connected to the upper interconnect level,
- a plurality of via connections for electrically connecting the semiconductor devices to the power delivery network,
characterized in that
- the first and a number of subsequent levels of the PDN are formed of electrical conductors embedded in a dielectric material,
- at least the two upper levels of the PDN include electrical conductors which are part of a manifold structure configured to receive therein a flow of cooling fluid flowing into and out of the manifold structure, in order to remove heat generated by the devices in the FEOL portion.

According to an embodiment, the manifold structure comprises an input port and an output port configured to direct respective input and output flows in a direction that is oriented essentially perpendicularly to the back to front direction of the component.

According to an embodiment :
- said at least two upper levels of the PDN each comprise an array of parallel line-shaped conductors interconnected by via connections, so that the spacing between each pair of parallel conductors forms a fluid channel and wherein the conductors of each pair of adjacent levels are arranged in crosswise fashion, so that a cooling fluid is able to flow from one level to an adjacent level and back,
- the manifold structure further comprises guiding elements for guiding a cooling fluid towards and away from said at least two upper levels of conductors.

According to an embodiment, said guiding elements include a floor portion at the same level as at least the lowest level of parallel conductors, a wall portion on said floor portion comprising wall elements which define a flow path for cooling fluid towards and from the conductors of one or more upper levels, and a cover on the wall portion.

According to an embodiment, said input and output ports are at the same level as the upper level of conductors of the manifold structure, and the guiding elements are configured so that a cooling fluid flowing from the inlet port to the outlet port is forced to flow between first selected pairs of upper-level conductors, thereafter downwards between conductors of one or more lower levels and again upwards so as to flow towards the outlet port between second selected pairs of upper-level conductors.

According to an embodiment, the guiding elements are formed of a non-electrically conductive material.

According to an embodiment, the guiding elements are formed of an electrically conductive material and an electrically non-conductive material separates the parallel conductors from the guiding elements.

According to an embodiment, said contact terminals are realized in the form of contact pads on the upper surface of the conductors of the upper level of the manifold structure.

According to an embodiment, the guiding elements include a cover and the cover is provided with openings for allowing the passage of the contact pads.

According to an embodiment, said electrical conductors of the PDN embedded in a dielectric material include crosswise arranged levels of line-shaped electrical conductors interconnected by via connections, wherein the density of said via connections is between 10% and 50%.

The invention is also related to a method for producing a component according to the invention, the method comprising the following steps :
- producing the front end of line portion on the front side of a semiconductor substrate,
- producing the back end of line portion on the front end of line portion,
- thereafter, attaching the front side of the substrate to a carrier,
- thereafter, thinning or removing the substrate from the back side,
- thereafter, producing a plurality of levels of the back side PDN, said plurality of levels being embedded in a dielectric material, said step ending with the production of a planar hybrid surface formed of said dielectric material with patches of a conductive material coplanar with the dielectric material,
- producing the manifold structure on said planar hybrid surface, wherein the levels of the PDN included in said manifold structure are contacting the patches of conductive material on the hybrid surface.

According to an embodiment of the method, the manifold structure is produced by one or more 3D printing steps.

According to an embodiment of the method, said at least two upper levels each comprise an array of parallel line-shaped conductors, so that the spacing between each pair of parallel conductors forms a fluid channel and the conductors of each pair of adjacent levels are arranged in crosswise fashion, so that a cooling fluid is able to flow from one level to an adjacent level and back, the manifold structure further comprising guiding elements for guiding a cooling fluid towards and away from said at least two upper levels of conductors, wherein:
- the conductors of said at least two upper levels are produced on the hybrid surface by a first 3D printing step,
- at least some of said guiding elements are produced on the hybrid surface by a second 3D printing step.

The method may further comprise the step of depositing a non-electrically conductive layer on all exposed surfaces of electrical conductors of the PDN which are part of the manifold structure.

The invention is equally relate to a stack of interconnected semiconductor chips, wherein the upper chip is a component in accordance with the invention and wherein said manifold structure and said terminals are oriented upwards so as to allow the supply of power to the stack via said terminals.

### Brief description of the figures

Figure 1 illustrates an integrated circuit chip in accordance with an embodiment of the invention.
Figures 2a and 2b are two section views according to two orthogonal section planes of a portion of the chip shown in Figure 1.
Figures 3 and 4 present 3D views taken from upper and lower viewpoints, of the manifold structure included in the chip shown in Figure 1, with the cover removed.
Figure 5 is a 3D view of the manifold structure including the cover.
Figure 6 is a further enlargement of a portion of the section view shown in Figure 2a, illustrating the constituent layers of the 'dry part' of the chip.
Figure 7 is an additional enlargement of a portion of the section view indicated in Figure 6, illustrating the structure of the FEOL portion and of the 'dry part' of the backside PDN.
Figures 8a to 8c illustrate the capabilities of a chip according to the invention when applied in a 3D logic/memory configuration.

### Detailed description of the invention

In the following detailed description, any reference to dimensions and materials is made by way of example only and does not limit the scope of the invention which is determined only by the appended claims.

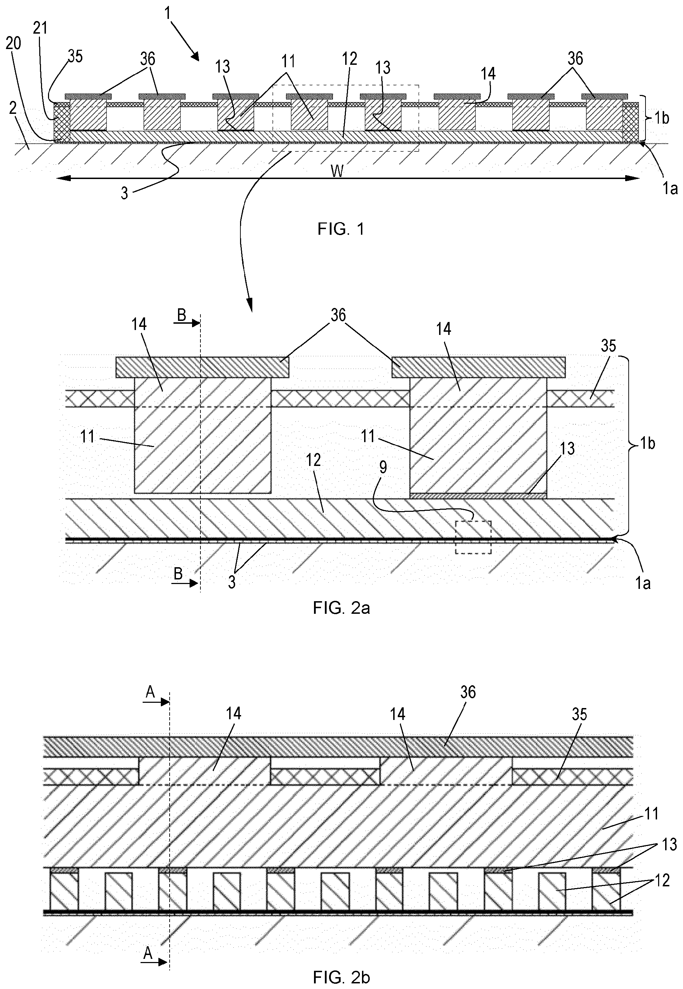

Figure 1 shows a cross-section of an integrated circuit chip 1 in accordance with an embodiment of the invention. The chip has a rectangular shape with a width W of about 5 mm. The length of the chip in the direction perpendicular to the section view in Figure 1 is longer than W, as will become apparent later. The chip may nevertheless by square instead of rectangular, and it may be larger than in the illustrated example. The dimensions and shape of the chip are not limited to specific values or forms.

The chip 1 is mounted on a carrier 2 which may be a printed circuit board or an interposer chip, by way of solder bump connections 3. The chip 1 may however also be part of a 3D stack, i.e. it may be stacked on top of another chip of the same or comparable size. As stated in the section 'summary of the invention', the chip 1 is divided in a 'dry part' 1a and a 'wet part' 1b, the latter corresponding mainly to a manifold structure configured to enable the passage of a cooling fluid. Details and constituent layers of the dry part 1a are not discernible in Figure 1 and will be described later in this text with reference to various enlarged images. The fact that electrical conductors incorporated in the manifold structure are part of a back side power delivery network of the chip 1 will also become apparent from the description of the 'dry part' 1a and the manner in which it is connected to the 'wet part' 1b.

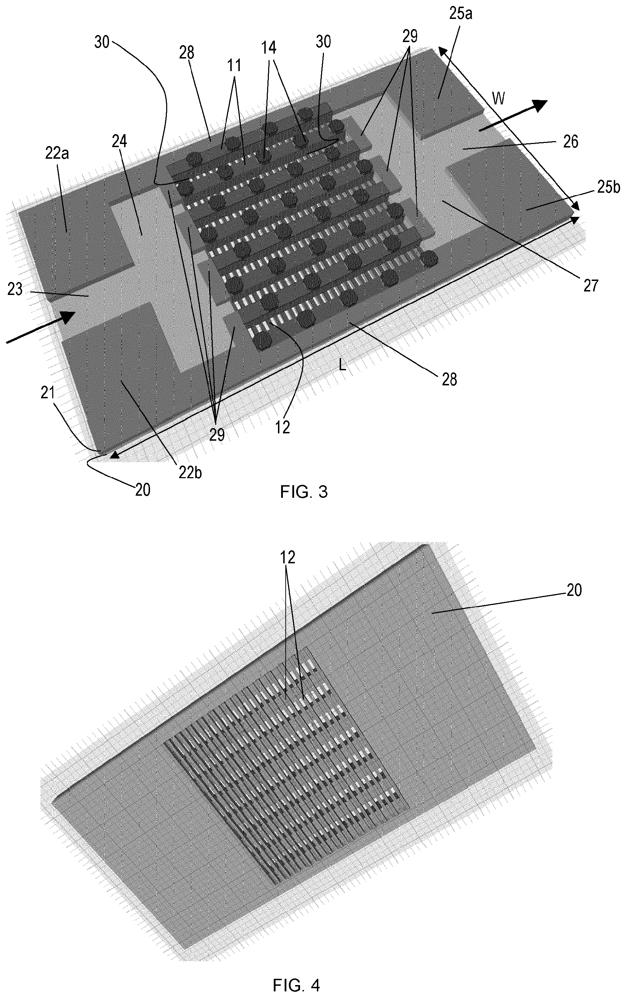

Before going into these aspects however, the manifold structure as such is first described, with reference to Figure 1, the enlarged images in Figure 2a and 2b and the 3D images in Figures 3 to 5. It is emphasized that the structure presented in these images is just one possible form of the manifold structure and that the invention is not limited to this particular form.

In Figures 1, 2a and 2b, it is seen that the manifold structure comprises two levels of electrical conductors, an upper level comprising an array of parallel conductors 11 and a lower level comprising an array of parallel conductors 12. The conductors of the two levels are arranged crosswise relative to each other and are interconnected by via connections 13. The combined height of the two levels is in the order of 300 µm. The upper level comprises 8 conductors 11, each provided with cylinder-shaped and regularly spaced contact pads 14 on their upper surface, said contact pads 14 being preferably integrally formed with the upper-level conductors 11. The lower level comprises a higher number of more narrow and more closely spaced conductors 12. The number of conductors in the upper and lower level may be much higher and has been kept deliberately low in the illustrated embodiment in order not to complicate the drawings.

In the 3D image shown in Figures 3 and 4, and also in the cross section in Figure 1, it is seen that the manifold structure further comprises guide elements for guiding a cooling fluid towards and away from the two levels of conductors 11 and 12. In the particular embodiment shown, these guide elements include a floor portion 20 and a wall portion 21 on top of the floor portion 20. In most practical embodiments, these portions are part of an integrally formed piece formed of a single material, but they are described here separately in order to clarify the functionality of these elements and their constituent parts. It can be seen in Figures 3 and 4 that the chip has a rectangular shape with the length L larger than the width W already referred to above in relation to the section shown in Figure 1.

As best seen in Figure 4, the floor portion 20 is closely fitted around the conductors 12 of the lower level and its height is about equal to the height of said lower-level conductors 12. Whenever used in this description, the wording 'closely fitting' when applied to adjacent components or surfaces indicates a proximity that realizes an effective seal between the adjacent components, when applied in combination with a suitable cooling fluid.

The wall portion 21 comprises wall elements which define a flow path of cooling fluid towards and from the upper-level conductors 11. The wall elements include on the inlet side a pair of sidewalls 22a and 22b for defining an inlet port 23 and an inlet collector area 24, and likewise on the outlet side sidewalls 25a and 25b for defining an outlet port 26 and an outlet collector area 27. The wall portion 21 further includes sidewalls 28 closely fitting against the sidewalls of the outer conductors 11 of the upper level, and blocking elements 29 closely fitting the outer ends of selected upper-level conductors 11, so as to create channels 30 which are in fluid communication with the inlet and outlet collector areas 24 and 27. The flow direction of a cooling fluid into and out of the manifold structure, as indicated by two arrows, is oriented perpendicularly to the chip in the embodiment shown. The invention is however not limited to manifold structures which require this flow direction.

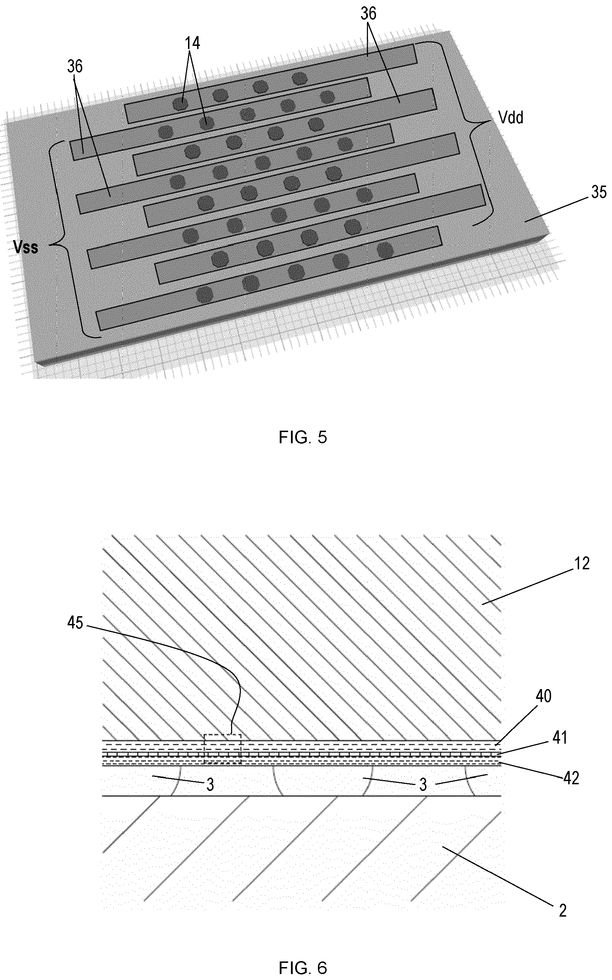

In order for the manifold structure to be able to conduct a flow of cooling fluid from the inlet port 23 to the outlet port 26, a cover 35 is mounted on the wall portion 21, as seen in Figures 1, 2a-2b and 5. The cover 35 is therefore also a flow guiding element, like the portions 20 and 21. Holes are provided in the cover 35 for allowing the passage of the contact pads 14, with the cover closely fitting around said contact pads. As seen in Figure 5 and also in Figures 1 and 2, contact leads 36 are connected to the rows of contact pads 14 protruding through the cover 35, for supplying power to the chip 1. The rectangles 36 in Figure 5 are merely intended to indicate the approximate position of the leads, and they are also shown in transparent view, so that the locations of the pads 14 are visible. The contact leads 36 are also not necessarily a part of the chip 1 when it is obtained as a finished product. A first set of 4 leads 36 are coupled to a supply voltage marked by the conventional notation Vdd, while a second set of 4 leads 36 are coupled to a reference voltage, conventionally marked as Vss, usually this is the ground potential. The upper-level conductors 11 are thereby alternately connected to Vdd and Vss. The via connections 13 between the upper and lower-level conductors are arranged so that also the lower-level conductors 12 are alternately connected to these two voltages.

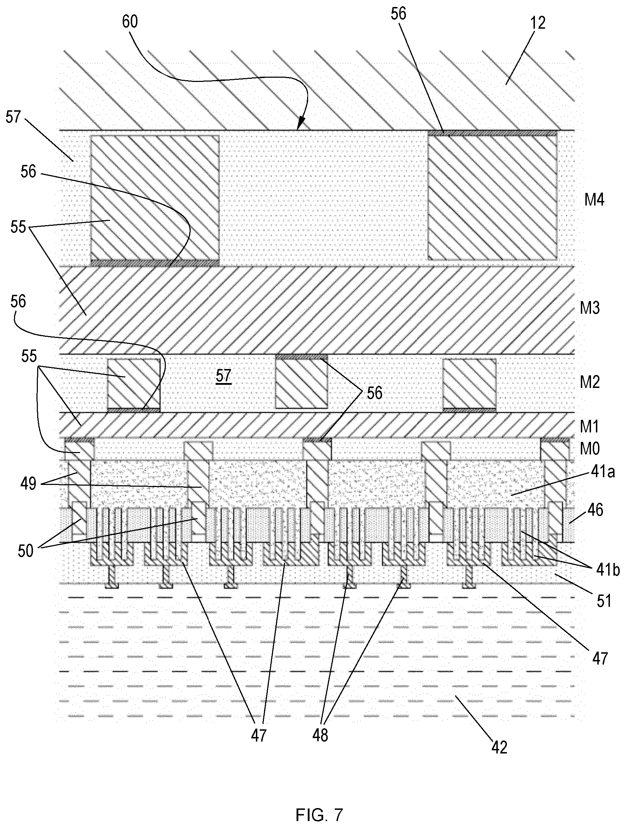

Below said lower-level conductors 12 are additional levels of the back side PDN which belong to the 'dry part' of the chip, described now in more detail with reference to the enlarged images shown in Figures 6 and 7. Figure 6 is an enlarged view of the rectangle 9 indicated in Figure 2a. Three distinct layers extend between the lower-level conductors 12 of the manifold structure and the solder bumps 3. The first layer 40 having a thickness in the order of 2.5 µm consists of the additional PDN levels. The second layer 41 is formed of a semiconductor substrate of less than 1 µm thick, with its front side oriented downward, i.e. the PDN is located on the back side of the substrate. On the front side of this substrate 41 is a plurality of active devices, which are not discernible on the scale of the image of Figure 6. These devices form the front end of line portion of the chip 1. These devices are connected to the solder bumps 3 through the multiple interconnected levels of the back end of line portion that forms the third layer 42, and which may also have a thickness in the order of a few µm.

A final enlargement of the rectangle 45 indicated in Figure 6 shows these constituent layers in more detail, in Figure 7, for one example of an applicable FEOL/BEOL/backside PDN structure. The image is conceptual rather than aimed at presenting a realistic structure. The BEOL portion 42 is not represented in detail. The substrate 41 is shown in more detail, and is seen to comprise a bulk portion 41a and a plurality of nano-sized fins 41b integral with said bulk portion 41a and separated by oxide regions 46, commonly referred to as STI regions (shallow trench isolation). Epitaxially grown contact areas 47 are represented as well, which may define for example source or drain areas of MOSFETs processed on the fins 41b. Some of the contact areas are coupled to the BEOL portion 42 through via connections 48 through a dielectric layer 51, while others are connected to a plurality of so-called 'through semiconductor via' connections (TSVs) 49 through a plurality of buried power rails 50. TSVs are via connections which pass through a bulk semiconductor substrate for connecting the front side of the substrate to the back side thereof. In most cases, these TSVs are separated from the semiconductor material by a dielectric liner (not shown in the drawing). In the appended claims, the term 'via connection' is used as a generic term for designating any vertical via connection, i.e. either a TSV or a via connection through a dielectric material. The invention is not limited to micro-electronic components comprising a bulk semiconductor substrate 41a and TSVs, as will be explained later. This configuration is merely used as an example for explaining how the 'wet part' of the component is coupled to the 'dry part'.

The TSVs 49 are connected to the first five levels M0 to M4 of the backside PDN. Like the two levels of the 'wet part', these 'dry' levels comprise multiple conductors 55 arranged in crosswise fashion and interconnected by via connections 56, wherein the dimensions of the conductors 55 increase from M0 to M1.

Contrary to the 'wet' PDN levels, the dry levels are embedded in a dielectric material 57, for example SiO₂ or a high-K dielectric. The upper surface of the dry part is a planar hybrid surface 60, i.e. a surface comprising mainly dielectric material with patches of metal coplanar with the dielectric, said patches forming the top surfaces of via connections 56. On this level hybrid surface 60, the manifold structure described above is positioned so that the lower-level conductors 12 of the manifold structure contact the via connections 56 on the hybrid surface 60. The 'dry' levels of the backside PDN are interconnected by the respective via connections 56 in such a manner that the supply voltage Vdd and the reference voltage Vss are effectively transferred through the subsequent levels, down to the active devices in the FEOL portion, for the purpose of supplying power to these devices. The conductors 11 and 12 of the manifold structure thus form levels M5 and M6 of the backside PDN.

In operation, the chip 1 is cooled by supplying a cooling fluid to the inlet port 23 of the manifold structure. The fluid flows through the three channels 30 between the upper conductors 11 which are not blocked by blocking elements 29 at the inlet side. As these channels are however blocked on the outlet side, the fluid is forced to flow between the conductors 12 of the lower level, emerging back upwards in the four upper channels 30 which are in fluid communication with the outlet port 26. This flow pattern thereby forces the cold fluid entering through the inlet port 23 to flow along the hybrid dielectric/metal surface 60 of the 'dry part', where it takes up heat produced by the devices in the FEOL, subsequently evacuating said heat by flowing out through the outlet port 26.

According to preferred embodiments, the cooling manifold is further combined with an optimized design of the 'dry part' in terms of the density and height of the via connections 56 in this dry part. By maximizing the via density and minimizing the height, thermal conductivity in the vertical direction across this 'dry part' can be optimized. According to embodiments, the via density in the dry part is between 10% and 50%. According to further embodiments, the via density is between 20% and 50%, or between 30% and 50% or between 40% and 50%. The height of the vias 56 (in all the 'dry' levels) is preferably as low as realistically attainable with the applied fabrication method, usually this is a single our double damascene processing technique. A via height between 5 - 50 nm or between 5 nm and 100 nm is for example applicable according to embodiments of the invention.

Producing a chip or other component according to the invention starts with a number of process steps which are well known in the art and which will only be briefly summarized hereafter, for the case of producing the chip 1 shown in Figures 1 to 7. The front end of line portion is first processed on the front side of a standard process wafer, which may be for example a 300 mm diameter monocrystalline silicon wafer or a silicon-on-insulator wafer. Then the BEOL portion 42 is produced on the FEOL portion by known damascene-type processing. The wafer is then flipped and temporarily bonded to a carrier substrate, and subsequently thinned from the backside by grinding and planarization techniques such as CMP (chemical mechanical polishing). The final very reduced thickness of the bulk substrate portion 41a is preferably obtained by wet etching, possibly stopping on an etch stop layer incorporated in the wafer. Then TSV openings may be formed by lithography and etching, followed by filling the openings with a dielectric liner and a metal (so-called 'TSV last' approach). However it is also possible to form the TSVs prior to processing the FEOL portion, and to thin the wafer until the pre-formed TSVs are exposed (TSV first approach). Following this, the first five PDN levels M0 to M4 are processed, again by damascene-type processing. The processing of the 'dry part' ends with the production of the planar hybrid dielectric/metal surface 60 onto which the manifold structure is to be formed.

As stated earlier, the invention is not limited to a configuration including TSV connections through a thin bulk substrate portion 41a as illustrated in Figure 7. The invention is equally applicable to an integrated circuit chip wherein no bulk substrate portion is left, i.e. the bulk of the substrate onto which fin-shaped Si-based devices or nano-sheet devices have been processed is completely removed from the back side and the connection to the back side PDN is realized by via connections through the STI material. The 'dry part' of the backside PDN is then produced on the revealed surface of this STI, i.e. directly on the back side of the FEOL portion, in the manner described above, i.e. by building for example layers M0 to M4, and stopping when the hybrid surface 60 is formed.

For this reason, it is stated in the appended claims that the FEOL and BEOL portions are located 'at the front side of the component', and the PDN is located 'at the back side of the component'. This can thus either mean that these layers are formed respectively on the front and back side of a bulk semiconductor substrate 41a, or that the PDN is formed directly on the back side of the FEOL portion.

The manifold structure can be obtained by a variety of techniques. The structure may for example be produced by one or more 3D printing steps. According to one embodiment, two printing steps are applied for producing the structure shown in Figure 3. First the two-level conductor structure comprising conductors 11 and 12 and via connections 13 is formed, using an electrically conductive material, for example aluminium. On the planar hybrid surface 60 referred to above, the Al is printed layer by layer, in accordance with a predefined scheme in terms of the positions of the lower and upper-level conductors 12 and 11 and the via connections 13. The contact pads 14 on the upper conductors 11 are formed in the same step. Then the surrounding floor and wall portions 20 and 21 are formed around the conductors 11 and 12 by a second 3D printing step, using a non-conducting, for example plastic or ceramic material that is able to withstand the applicable temperatures in the manifold structure, which may be up to 100°C. One example of a suitable 3D-printable non-electrically conducting plastic material is the material Somos^{®} perFORM from DSM.

Alternatively, a single 3D printing step may be done, using two different materials in the respective predefined areas for the conductors 11/12/13 (metal) and the floor and wall portions 20/21 (insulating material).

The cover 35 may equally be formed by continued 3D printing above the level of the wall portion 21. This can be done using a known printing technique that enables the formation of cavities, for example by printing layers in a given area and illuminating the material down to a given depth in order to change the material from solid to liquid or vice versa, so that unwanted material can be removed from the inside of a cavity after the printing and illumination steps.

Alternatively, the cover 35 may be formed by a separate 3D printing step or by another manufacturing method, in the form of a plate provided with holes at the positions of the contact pads 14. The cover may then be assembled to the wall portion 21 by fitting it over the contact pads 14 and attaching it to the upper surface of the wall portion 21 by a watertight adhesive.

According to yet another alternative, the two-level conductor structure 11/12/13,the floor and wall portions 20/21 may be formed simultaneously in a single 3D printing step, using the same electrically conductive material, for example aluminium for the conductors as well as for the floor and wall portions and possibly the cover, but applying an isolation layer between adjacent parts of the conductors and the floor and wall portions.

The cover 35 could also be formed of metal. In that case however, an isolation layer needs to be applied on the upper conductors 11 and on the sidewalls of the contact pads 14, for isolating these components from the cover.

Another way of obtaining the manifold structure could be to form the two-level conductor structure 11/12/13 by milling a rectangular piece of metal such as aluminium, and bonding the structure to the hybrid dielectric/metal surface 60 of the dry part. The floor and wall portions 20/21 could then again be formed by 3D printing.

All of the above-described process steps are preferably performed on wafer level, i.e. before the process wafer is separated into separate chips and/or other components. The finished chip 1 may then be released from the carrier and bonded to a PCB or interposer in the manner illustrated in Figure 1.

In prior art configurations including a back side PDN, it may be necessary to maintain the carrier in the final chip (i.e. to separate the carrier also by dicing), in order to provide sufficient mechanical stability to the chip. In a chip according to the invention, the manifold structure is much thicker than the FEOL/BEOL and 'dry' PDN part combined, so that this manifold structure lends mechanical stability to the chip. A carrier on the opposite side may therefore be omitted.

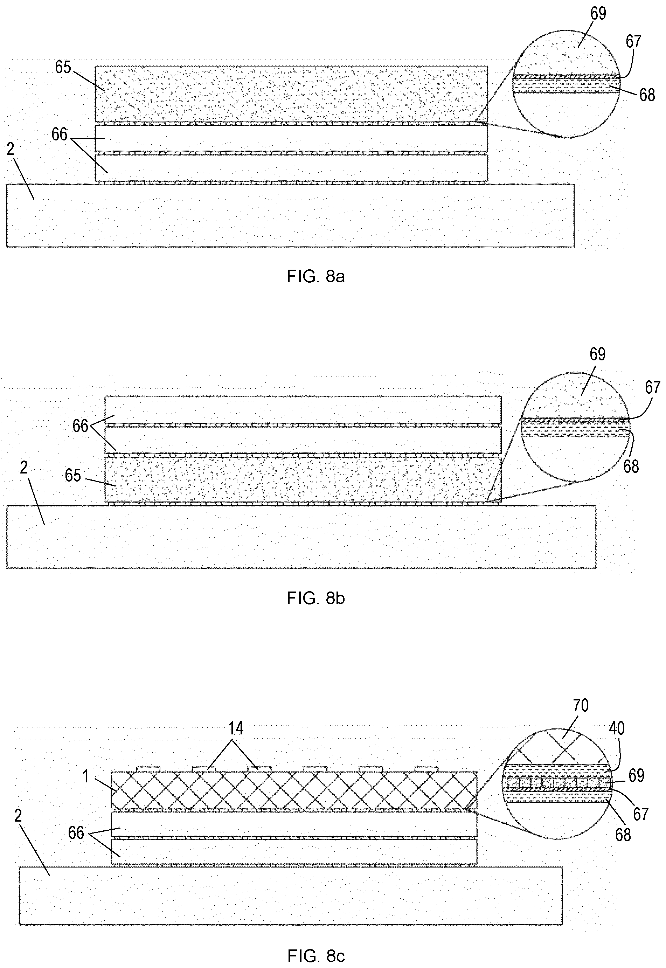

The invention is also applicable to a chip bonded to one or more other chips in a 3D chip stacking technology. Here the advantages of the invention are especially apparent. This is explained using some example configurations shown in Figures 8a to 8c. Figure 8a is a first prior art configuration of a stack of interconnected chips bonded to a PCB 2. The stack comprises a logic chip 65 and two memory chips 66. The logic chip 65 conventionally comprises a FEOL portion 67 and a BEOL portion 68 on the front side of a semiconductor substrate portion 69 of the chip, with the power delivery network incorporated in the BEOL portion 68. The logic chip 65 is bonded face down the stack of memory chips 66. In this configuration, power is supplied from the PCB 2 to the logic chip 65, which requires dedicated power supply pins on all of the memory chips 66. This means that the power delivery will be severely constrained by (i) the resistance of the connections through the memory chips 66 as well as (ii) the competition in use of the available 3d vertical interconnections for power supply of the logic chip 65 and for signal connectivity across the 3d chip stack. Cooling this stack can be done by cooling the back side of the logic chip 65. As the thermal conductivity of the substrate 69 is relatively high, and there are essentially no thermally insulating materials between the FEOL portion 67 and the back of the chip, cooling this configuration is therefore relatively easy.

Figure 8b illustrates a second prior art configuration. The logic chip 65 is now bonded directly to the PCB, i.e. the front side PDN contacts the PCB and the memory chips are stacked on top of the logic chip 65. The FEOL and BEOL portions 67 and 68 are indicated as well. Via connections (not shown) through the substrate 69 connect the logic chip 65 to the memory chips 66.

In the configuration of Figure 8b, a much more direct, lower resistance power supply of the logic chip can be accomplished, but there still is competition in the use of 3d interconnects between the logic chip 65 and the PCB 2 for power on one hand and signalling on the other. Furthermore, cooling the logic chip 65 is more difficult because it is now at the bottom of the stack, with the memory chips 66 in between the logic chip and a heat sink.

The image in Figure 8c illustrates a configuration that is enabled by the present invention, at the same time optimizing cooling, power delivery and availability of signal interconnects across the 3d chip stack. The logic chip 1 is in accordance with the invention and may be realized as shown in Figure 1 or according to any other embodiment of the invention. The thinned semiconductor substrate 69, and the FEOL and BEOL portions 67 and 68 are again indicated. The 'dry part' of the back side PDN is indicated and referenced by the same numeral 40 as in the previous parts of the description. The 'wet part' 70 of the back side PDN, including a manifold structure as described above or according to any other embodiment is not shown in detail, apart from a number of power supply terminals 14. The logic chip 1 is placed at the top of the stack with the 'wet part' oriented upwards. Power is supplied therefore to the top of the stack, to the terminals 14, while the stack is cooled from the top side by supplying a cooling fluid to the manifold structure. It is clear that this configuration enables (i) good cooling capability (ii) good power delivery to the logic chip (iii) high availability of connection across the 3d chip stack for signalling.

The cooling fluid applied when the chip is operational may be water or any other suitable fluid in the liquid or gaseous state. The fluid may be electrically conductive or non-conductive. In the first case, an isolation layer needs to be applied on all the surfaces of the conductors 11 and 12 and the via connections 13 that are exposed to the fluid. One way of applying such a layer is by a technique applicable for example on a manifold structure wherein the conductors 11 and 12 are formed of aluminium. According to this technique, an alkaline solution is supplied to the finished manifold structure, i.e. flowing from the inlet port to the outlet port, followed by a supply of boiling demineralized water or steam, resulting in the deposition of a aluminium oxide layer on all of the exposed Al surfaces. The alkaline solution removes native oxides from the aluminium. The treatment with water or steam results in the controlled formation of an Al oxide layer that will isolate the conductors electrically. This technique is known as such, and described for example in the document entitled "Accelerated growth of oxide film on aluminium alloys under steam: Part II: Effects of alloy chemistry and steam vapour pressure on corrosion and adhesion performance", Surface and Coatings Technology, Volume 276, 25 August 2015, Pages 106-115.

However, if no such oxide layer has been deposited, the manifold structure can be used in combination with any suitable non-electrically conductive cooling fluid known in the art.

As already indicated, the invention is not limited to the specific manifold structure illustrated in the drawings. The number of PDN levels incorporated in the manifold structure could be higher than 2. The inlet and outlet ports could be arranged differently from the illustrated embodiment, for example oriented at right angles relative to each other and placed at the level of different PDN levels. The fluid could also enter the chip vertically through an opening in the cover 35, and flow out of the component vertically as well, or a combination of different in and outflow directions could be applied.

While the invention has been illustrated and described in detail in the drawings and foregoing description, such illustration and description are to be considered illustrative or exemplary and not restrictive. In the claims, the word "comprising" does not exclude other elements or steps, and the indefinite article "a" or "an" does not exclude a plurality. Any reference signs in the claims should not be construed as limiting the scope.

## Claims

1. A micro-electronic component (1) having a front side and a back side, the component comprising :
- at the front side of the component : a front end of line (FEOL) portion comprising a plurality of semiconductor devices and on said FEOL portion : a back end of line (BEOL) portion (42) comprising multiple interconnect levels,
- at the back side of the component : a power delivery network (PDN) comprising multiple interconnect levels, and power supply terminals (14) electrically connected to the upper interconnect level,
- a plurality of via connections (49) for electrically connecting the semiconductor devices to the power delivery network,
**characterized in that**
- the first and a number of subsequent levels of the PDN are formed of electrical conductors (55,56) embedded in a dielectric material (57),
- at least the two upper levels of the PDN include electrical conductors (11,12,13) which are part of a manifold structure configured to receive therein a flow of cooling fluid flowing into and out of the manifold structure, in order to remove heat generated by the devices in the FEOL portion.

2. The component (1) according to any one of the preceding claims, wherein the manifold structure comprises an input port (23) and an output port (26) configured to direct respective input and output flows in a direction that is oriented essentially perpendicularly to the back to front direction of the component (1).

3. The component (1) according to claim 1 or 2, wherein
- said at least two upper levels of the PDN each comprise an array of parallel line-shaped conductors (11,12) interconnected by via connections (13), so that the spacing between each pair of parallel conductors (11,12) forms a fluid channel (30) and wherein the conductors of each pair of adjacent levels are arranged in crosswise fashion, so that a cooling fluid is able to flow from one level to an adjacent level and back,
- the manifold structure further comprises guiding elements (20,21,35) for guiding a cooling fluid towards and away from said at least two upper levels of conductors (11,12).

4. The component (1) according to claim 3, wherein said guiding elements include a floor portion (20) at the same level as at least the lowest level of parallel conductors (12), a wall portion (21) on said floor portion comprising wall elements which define a flow path for cooling fluid towards and from the conductors (11) of one or more upper levels, and a cover (35) on the wall portion (21).

5. The component (1) according to claim 3 or 4, wherein said input and output ports (23,26) are at the same level as the upper level of conductors (11) of the manifold structure, and wherein the guiding elements (20,21,35) are configured so that a cooling fluid flowing from the inlet port (23) to the outlet port (26) is forced to flow between first selected pairs of upper-level conductors (11), thereafter downwards between conductors (12) of one or more lower levels and again upwards so as to flow towards the outlet port between second selected pairs of upper-level conductors (11).

6. The component (1) according to any one of claims 3 to 5, wherein the guiding elements (20,21,35) are formed of a non-electrically conductive material.

7. The component (1) according to any one of claims 3 to 5, wherein the guiding elements (20,21,35) are formed of an electrically conductive material and wherein an electrically non-conductive material separates the parallel conductors (11,12) from the guiding elements.

8. The component (1) according to any one of claims 3 to 7, wherein said contact terminals are realized in the form of contact pads (14) on the upper surface of the conductors (11) of the upper level of the manifold structure.

9. The component (1) according to claim 8, wherein the guiding elements include a cover (35) and wherein the cover is provided with openings for allowing the passage of the contact pads (14).

10. The component (1) according to any one of the preceding claims, wherein said electrical conductors (55,56) of the PDN embedded in a dielectric material (57) include crosswise arranged levels of line-shaped electrical conductors (55) interconnected by via connections (56), and wherein the density of said via connections (56) is between 10% and 50%.

11. A method for producing a component according to any one of the preceding claims, the method comprising the following steps :
- producing the front end of line portion on the front side of a semiconductor substrate,
- producing the back end of line portion (42) on the front end of line portion,
- thereafter, attaching the front side of the substrate to a carrier,
- thereafter, thinning or removing the substrate from the back side,
- thereafter, producing a plurality of levels of the back side PDN, said plurality of levels being embedded in a dielectric material (57), said step ending with the production of a planar hybrid surface (60) formed of said dielectric material with patches of a conductive material coplanar with the dielectric material,
- producing the manifold structure on said planar hybrid surface (60), wherein the levels of the PDN included in said manifold structure are contacting the patches of conductive material on the hybrid surface.

12. The method according to claim 11, wherein the manifold structure is produced by one or more 3D printing steps.

13. The method according to claim 11 or 12, wherein said at least two upper levels each comprise an array of parallel line-shaped conductors (11,12), so that the spacing between each pair of parallel conductors forms a fluid channel (30) and wherein the conductors of each pair of adjacent levels are arranged in crosswise fashion, so that a cooling fluid is able to flow from one level to an adjacent level and back, the manifold structure further comprising guiding elements (20,21,35) for guiding a cooling fluid towards and away from said at least two upper levels of conductors, and wherein:
- the conductors (11,12) of said at least two upper levels are produced on the hybrid surface (60) by a first 3D printing step,
- at least some of said guiding elements (20,21,35) are produced on the hybrid surface (60) by a second 3D printing step.

14. The method according to any one of claims 11 to 13, further comprising the step of depositing a non-electrically conductive layer on all exposed surfaces of electrical conductors (11,12,13) of the PDN which are part of the manifold structure.

15. A stack of interconnected semiconductor chips (1,66), wherein the upper chip (1) is a component in accordance with any one of claims 1 to 10 and wherein said manifold structure and said terminals (14) are oriented upwards so as to allow the supply of power to the stack via said terminals.

## Patentansprüche

1. Mikroelektronisches Bauteil (1), das eine Vorderseite und eine Rückseite aufweist, wobei das Bauteil umfasst:
- an der Vorderseite des Bauteils: ein Front-End-of-Line-, (FEOL)-Abschnitt, der eine Vielzahl von Halbleitervorrichtungen umfasst, und auf dem FEOL-Abschnitt: ein Back-End-of-Line-, (BEOL)-Abschnitt (42), der mehrere Verbindungsebenen umfasst,
- auf der Rückseite des Bauteils: ein Stromversorgungsnetz (PDN), das mehrere Verbindungsebenen umfasst, und Stromanschlüsse (14), die elektrisch mit der oberen Verbindungsebene verbunden sind,
- eine Vielzahl von Durchkontaktierungsverbindungen (49) zum elektrischen Verbinden der Halbleitervorrichtungen mit dem Stromversorgungsnetz, **dadurch gekennzeichnet, dass**
- die erste und eine Anzahl nachfolgender Ebenen des PDN aus elektrischen Leitern (55,56) gebildet sind, die in ein dielektrisches Material (57) eingebettet sind,
- mindestens die beiden oberen Ebenen des PDN elektrische Leiter (11,12,13) beinhalten, die Teil einer Verteilerstruktur sind, die konfiguriert ist, um darin einen Kühlfluidstrom aufzunehmen, der in die und aus der Verteilerstruktur strömt, um die von den Vorrichtungen im FEOL-Abschnitt erzeugte Wärme abzuführen.

2. Bauteil (1) nach einem der vorstehenden Ansprüche, wobei die Verteilerstruktur einen Eingangsanschluss (23) und einen Ausgangsanschluss (26) umfasst, die konfiguriert sind, um jeweilige Eingangs- und Ausgangsströme in eine Richtung zu leiten, die im Wesentlichen senkrecht zur Rückwärts-Vorwärts-Richtung des Bauteils (1) ausgerichtet ist.

3. Bauteil (1) nach Anspruch 1 oder 2, wobei
- die mindestens zwei oberen Ebenen des PDN jeweils eine Anordnung paralleler linienförmiger Leiter (11,12) umfassen, die durch Durchkontaktierungsverbindungen (13) miteinander verbunden sind, sodass der Abstand zwischen jedem Paar paralleler Leiter (11,12) einen Fluidkanal (30) bildet, und wobei die Leiter jedes Paares benachbarter Ebenen kreuzweise angeordnet sind, sodass ein Kühlfluid imstande ist, von einer Ebene zu einer benachbarten Ebene und zurück zu strömen,
- die Verteilerstruktur weiter Führungselemente (20,21,35) zum Führen eines Kühlfluids in Richtung der mindestens zwei oberen Leiterebenen (11,12) und davon weg umfasst.

4. Bauteil (1) nach Anspruch 3, wobei die Führungselemente einen Bodenabschnitt (20) auf derselben Ebene wie mindestens die unterste Ebene der parallelen Leiter (12), einen Wandabschnitt (21) auf dem Bodenabschnitt, der Wandelemente umfasst, die einen Strömungsweg für Kühlfluid zu und von den Leitern (11) einer oder mehrerer oberer Ebenen definieren, und eine Abdeckung (35) auf dem Wandabschnitt (21) beinhalten.

5. Bauteil (1) nach Anspruch 3 oder 4, wobei sich die Eingangs- und Ausgangsanschlüsse (23,26) auf derselben Ebene wie die obere Ebene von Leitern (11) der Verteilerstruktur befinden, und wobei die Führungselemente (20,21,35) so konfiguriert sind, dass ein Kühlfluid, das vom Eingangsanschluss (23) zum Ausgangsanschluss (26) strömt, gezwungen ist, zwischen ersten ausgewählten Paaren von Leitern (11) der oberen Ebene zu strömen, danach abwärts zwischen Leitern (12) einer oder mehrerer unterer Ebenen und wieder aufwärts, um in Richtung des Ausgangsanschlusses zwischen zweiten ausgewählten Paaren von Leitern (11) der oberen Ebene zu strömen.

6. Bauteil (1) nach einem der Ansprüche 3 bis 5, wobei die Führungselemente (20,21,35) aus einem nicht elektrisch leitenden Material gebildet sind.

7. Bauteil (1) nach einem der Ansprüche 3 bis 5, wobei die Führungselemente (20,21,35) aus einem elektrisch leitfähigen Material gebildet sind und wobei ein elektrisch nicht leitfähiges Material die parallelen Leiter (11,12) von den Führungselementen trennt.

8. Bauteil (1) nach einem der Ansprüche 3 bis 7, wobei die Kontaktanschlüsse in Form von Kontaktstellen (14) auf der oberen Oberfläche der Leiter (11) der oberen Ebene der Verteilerstruktur ausgeführt sind.

9. Bauteil (1) nach Anspruch 8, wobei die Führungselemente eine Abdeckung (35) beinhalten und wobei die Abdeckung mit Öffnungen bereitgestellt ist, um den Durchgang der Kontaktstellen (14) zu ermöglichen.

10. Bauteil (1) nach einem der vorstehenden Ansprüche, wobei die elektrischen Leiter (55,56) des PDN, die in ein dielektrisches Material (57) eingebettet sind, kreuzweise angeordnete Ebenen linienförmiger elektrischer Leiter (55) beinhalten, die durch Durchkontaktierungsverbindungen (56) miteinander verbunden sind, und wobei die Dichte der Durchkontaktierungsverbindungen (56) zwischen 10% und 50% liegt.

11. Verfahren zum Herstellen eines Bauteils nach einem der vorstehenden Ansprüche, wobei das Verfahren die folgenden Schritte umfasst:
- Herstellen des Front-End-of-Line-Abschnitts auf der Vorderseite eines Halbleitersubstrats,
- Herstellen des Back-End-of-Line-Abschnitts (42) auf dem Front-End-of-Line-Abschnitt, - danach Befestigen der Vorderseite des Substrats auf einem Träger,
- danach Ausdünnen oder Entfernen des Substrats von der Rückseite,
- danach Herstellen einer Vielzahl von Ebenen des Rückseiten-PDN, wobei die Vielzahl von Ebenen in ein dielektrisches Material (57) eingebettet sind, wobei der Schritt mit der Herstellung einer planaren Hybridoberfläche (60) endet, die aus dem dielektrischen Material mit Flecken aus einem leitfähigen Material komplanar zum dielektrischen Material gebildet wird,
- Herstellen der Verteilerstruktur auf der planaren Hybridoberfläche (60), wobei die Ebenen des in der Verteilerstruktur beinhalteten PDN die Flecken aus leitfähigem Material auf der Hybridoberfläche berühren.

12. Verfahren nach Anspruch 11, wobei die Verteilerstruktur durch einen oder mehrere 3D-Druckschritte hergestellt wird.

13. Verfahren nach Anspruch 11 oder 12, wobei die mindestens zwei oberen Ebenen jeweils eine Anordnung paralleler linienförmiger Leiter (11,12) umfassen, sodass der Abstand zwischen jedem Paar paralleler Leiter einen Fluidkanal (30) bildet, und wobei die Leiter jedes Paares benachbarter Ebenen kreuzweise angeordnet sind, sodass ein Kühlfluid imstande ist, von einer Ebene zu einer benachbarten Ebene und zurück zu strömen, wobei die Verteilerstruktur weiter Führungselemente (20,21,35) zum Führen eines Kühlfluids zu den mindestens zwei oberen Leiterebenen hin und von diesen weg umfasst, und wobei:
- die Leiter (11,12) der mindestens zwei oberen Ebenen durch einen ersten 3D-Druckschritt auf der Hybridoberfläche (60) hergestellt werden,
- mindestens einige der Führungselemente (20,21,35) durch einen zweiten 3D-Druckschritt auf der Hybridoberfläche (60) hergestellt werden.

14. Verfahren nach einem der Ansprüche 11 bis 13, das weiter den Schritt des Aufbringens einer nicht elektrisch leitenden Schicht auf alle freiliegenden Oberflächen der elektrischen Leiter (11,12,13) des PDN umfasst, die Teil der Verteilerstruktur sind.

15. Stapel aus miteinander verbundenen Halbleiterchips (1,66), wobei der obere Chip (1) ein Bauteil nach einem der Ansprüche 1 bis 10 ist, und wobei die Verteilerstruktur und die Anschlüsse (14) nach oben ausgerichtet sind, um die Stromversorgung des Stapels über die Anschlüsse zu ermöglichen.

## Revendications

1. Composant microélectronique (1) présentant une face avant et une face arrière, le composant comprenant :
- au niveau de la face avant du composant : une partie d'extrémité avant de ligne (FEOL) comprenant une pluralité de dispositifs semi-conducteurs et sur ladite partie FEOL : une partie d'extrémité arrière de ligne (BEOL) (42) comprenant de multiples niveaux d'interconnexion,
- au niveau de la face arrière du composant : un réseau de distribution d'énergie (PDN) comprenant de multiples niveaux d'interconnexion et des bornes d'alimentation (14) connectées électriquement au niveau d'interconnexion supérieur,
- une pluralité de connexions de trou de liaison (49) pour connecter électriquement les dispositifs semi-conducteurs au réseau de distribution d'énergie, **caractérisé en ce que**
- le premier et un nombre de niveaux suivants du PDN sont formés de conducteurs électriques (55, 56) intégrés dans un matériau diélectrique (57),
- au moins les deux niveaux supérieurs du PDN incluent des conducteurs électriques (11, 12, 13) qui font partie d'une structure de collecteur configurée pour recevoir dans celle-ci un flux de fluide de refroidissement entrant et sortant de la structure de collecteur, afin d'évacuer la chaleur générée par les dispositifs dans la partie FEOL.

2. Composant (1) selon l'une quelconque des revendications précédentes, dans lequel la structure de collecteur comprend un orifice d'entrée (23) et un orifice de sortie (26) configurés pour diriger les flux d'entrée et de sortie respectifs dans une direction qui est orientée sensiblement perpendiculairement à la direction arrière-avant du composant (1).

3. Composant (1) selon la revendication 1 ou 2, dans lequel
- lesdits au moins deux niveaux supérieurs du PDN comprennent chacun un réseau de conducteurs linéaires parallèles (11, 12) interconnectés par des connexions de trou de liaison (13), de sorte que l'espacement entre chaque paire de conducteurs parallèles (11, 12) forme un canal de fluide (30) et dans lequel les conducteurs de chaque paire de niveaux adjacents sont agencés transversalement, de sorte qu'un fluide de refroidissement peut circuler d'un niveau à un niveau adjacent et inversement,
- la structure de collecteur comprend en outre des éléments guides (20, 21, 35) pour guider un fluide de refroidissement vers et à l'écart desdits au moins deux niveaux supérieurs de conducteurs (11, 12).

4. Composant (1) selon la revendication 3, dans lequel lesdits éléments guides incluent une partie de plancher (20) au même niveau qu'au moins le niveau le plus bas des conducteurs parallèles (12), une partie de paroi (21) sur ladite partie de plancher comprenant des éléments de paroi qui définissent un trajet d'écoulement pour le fluide de refroidissement vers et depuis les conducteurs (11) d'un ou de plusieurs niveaux supérieurs et un couvercle (35) sur la partie de paroi (21).

5. Composant (1) selon la revendication 3 ou 4, dans lequel lesdits orifices d'entrée et de sortie (23, 26) sont au même niveau que le niveau supérieur des conducteurs (11) de la structure de collecteur, et dans lequel les éléments guides (20, 21, 35) sont configurés de telle sorte qu'un fluide de refroidissement s'écoulant de l'orifice d'entrée (23) vers l'orifice de sortie (26) est forcé de s'écouler entre des premières paires sélectionnées de conducteurs de niveau supérieur (11), puis vers le bas entre des conducteurs (12) d'un ou de plusieurs niveaux inférieurs et de nouveau vers le haut de manière à s'écouler vers l'orifice de sortie entre des secondes paires sélectionnées de conducteurs de niveau supérieur (11).

6. Composant (1) selon l'une quelconque des revendications 3 à 5, dans lequel les éléments guides (20, 21, 35) sont formés d'un matériau non électroconducteur.

7. Composant (1) selon l'une quelconque des revendications 3 à 5, dans lequel les éléments guides (20, 21, 35) sont formés d'un matériau électroconducteur et dans lequel un matériau non électroconducteur sépare les conducteurs parallèles (11, 12) des éléments guides.

8. Composant (1) selon l'une quelconque des revendications 3 à 7, dans lequel lesdites bornes de contact sont réalisées sous forme de plots de contact (14) sur la surface supérieure des conducteurs (11) du niveau supérieur de la structure de collecteur.

9. Composant (1) selon la revendication 8, dans lequel les éléments guides incluent un couvercle (35) et dans lequel le couvercle est doté d'ouvertures pour permettre le passage des plots de contact (14).

10. Composant (1) selon l'une quelconque des revendications précédentes, dans lequel lesdits conducteurs électriques (55, 56) du PDN intégrés dans un matériau diélectrique (57) incluent des niveaux agencés transversalement de conducteurs électriques linéaires (55) interconnectés par des connexions de trou de liaison (56), et dans lequel la densité desdites connexions de trou de liaison (56) est comprise entre 10 % et 50 %.

11. Procédé de production d'un composant selon l'une quelconque des revendications précédentes, le procédé comprenant les étapes suivantes :
- la production de la partie d'extrémité avant de ligne sur la face avant d'un substrat semi-conducteur,
- la production de la partie d'extrémité arrière de ligne (42) sur la partie d'extrémité avant de ligne, - ensuite, la fixation de la face avant du substrat à un support,
- ensuite, l'amincissement ou le retrait du substrat de la face arrière,
- ensuite, la production d'une pluralité de niveaux du PDN arrière, ladite pluralité de niveaux étant intégrés dans un matériau diélectrique (57), ladite étape se terminant par la production d'une surface hybride plane (60) formée dudit matériau diélectrique avec des zones d'un matériau conducteur coplanaires avec le matériau diélectrique,
- la production de la structure de collecteur sur ladite surface hybride plane (60), dans lequel les niveaux du PDN inclus dans ladite structure de collecteur sont en contact avec les zones de matériau conducteur sur la surface hybride.

12. Procédé selon la revendication 11, dans lequel la structure de collecteur est produite par une ou plusieurs étapes d'impression 3D.

13. Procédé selon la revendication 11 ou 12, dans lequel lesdits au moins deux niveaux supérieurs comprennent chacun un réseau de conducteurs linéaires parallèles (11, 12), de sorte que l'espacement entre chaque paire de conducteurs parallèles forme un canal de fluide (30) et dans lequel les conducteurs de chaque paire de niveaux adjacents sont agencés transversalement, de sorte qu'un fluide de refroidissement peut circuler d'un niveau à un niveau adjacent et inversement, la structure de collecteur comprenant en outre des éléments guides (20, 21, 35) pour guider un fluide de refroidissement vers et à l'écart desdits au moins deux niveaux supérieurs de conducteurs, et dans lequel :
- les conducteurs (11, 12) desdits au moins deux niveaux supérieurs sont produits sur la surface hybride (60) par une première étape d'impression 3D,
- au moins certains desdits éléments guides (20, 21, 35) sont produits sur la surface hybride (60) par une seconde étape d'impression 3D.

14. Procédé selon l'une quelconque des revendications 11 à 13, comprenant en outre l'étape de dépôt d'une couche non électroconductrice sur toutes les surfaces exposées des conducteurs électriques (11, 12, 13) du PDN qui font partie de la structure de collecteur.

15. Empilement de puces semi-conductrices interconnectées (1, 66), dans lequel la puce supérieure (1) est un composant selon l'une quelconque des revendications 1 à 10 et dans lequel ladite structure de collecteur et lesdites bornes (14) sont orientées vers le haut de manière à permettre l'alimentation électrique de l'empilement par l'intermédiaire desdites bornes.
